Europäisches Patentamt

European Patent Office

Office européen des brevets

(19)

(11) Numéro de publication : **0 425 051 B1**

(12) # FASCICULE DE BREVET EUROPEEN

(45) Date de publication du fascicule du brevet :
28.06.95 Bulletin 95/26

(51) Int. Cl.⁶ : **H04N 7/24, H04N 5/92**

(21) Numéro de dépôt : **90202837.2**

(22) Date de dépôt : **24.10.90**

(54) **Dispositif de codage comportant un codeur à mots de longueur variable et dispositif de décodage associé.**

(30) Priorité : **27.10.89 FR 8914141**

(43) Date de publication de la demande :
**02.05.91 Bulletin 91/18**

(45) Mention de la délivrance du brevet :
**28.06.95 Bulletin 95/26**

(84) Etats contractants désignés :
**DE FR GB IT**

(56) Documents cités :
**EP-A- 0 310 175
EP-A- 0 323 363
GB-A- 2 215 555
US-A- 4 369 464
NTC 1979 CONFERENCE RECORD, Washington, 27-29 novembre 1979, vol. 3, pages
5351-5356; R.F. RICE et al.: "Block adaptive
rate controlled image datacompression"**

(73) Titulaire : **LABORATOIRES D'ELECTRONIQUE
PHILIPS
22, avenue Descartes
F-94453 Limeil-Brévannes Cédex (FR)**
(84) **FR**
Titulaire : **Philips Electronics N.V.
Groenewoudseweg 1
NL-5621 BA Eindhoven (NL)**
(84) **DE GB IT**

(72) Inventeur : **Lhuillier, Jean-Jacques
SOCIETE CIVILE S.P.I.D.,
156 Bd Haussmann
F-75008 Paris (FR)**
Inventeur : **Guichard, Philippe
SOCIETE CIVILE S.P.I.D.,
156 Bd Haussmann
F-75008 Paris (FR)**

(74) Mandataire : **Chaffraix, Jean et al
Société Civile S.P.I.D.
156, Boulevard Haussmann
F-75008 Paris (FR)**

## Description

La présente invention concerne un dispositif de codage comportant un codeur à mots de longueur variable muni d'une commande de qualité pour déterminer des caractéristiques de codage différentes, dispositif comportant une entrée d'informations à coder se présentant sous la forme de paquets de blocs d'informations numériques d'images à appliquer au codeur, une mémoire tampon pour recevoir les informations codées issues dudit codeur et pour les restituer à une borne de sortie avec un débit fixe et un circuit de régulation pour définir pour chaque bloc une qualité en fonction d'une part du nombre réel d'éléments binaires utilisés pour le codage de chaque bloc et d'autre part d'une grandeur résiduelle définissant le nombre d'éléments binaires contenus dans la mémoire tampon après le codage de chaque paquet.

Un tel dispositif trouve d'importantes applications, notamment dans le domaine de la télévision numérique. Ainsi chaque paquet peut représenter une image et chaque bloc une zone de cette image contenant un ensemble de points d'images.

Ceci est décrit dans la demande de brevet européen EP-A-0 310 175. Pour profiter pleinement des avantages du codeur à mots de longueur variable, il y a intérêt à utiliser une mémoire tampon de grande capacité qui peut absorber ainsi des inégalités importantes de longueur des mots codés. Cependant, lorsqu'on veut enregistrer sur bande magnétique de telles images codées, il s'est imposé l'exigence que chaque image soit codée avec un nombre à peu près constant d'éléments binaires afin d'occuper sur la bande magnétique un espace fixe. Ainsi la recherche rapide d'une séquence d'images enregistrées s'en trouve facilitée. Les dispositifs connus sont donc contraints d'utiliser une mémoire tampon dont la capacité dépend de la tolérance accordée à cet espace. Cette capacité est alors nécessairement faible.

La présente invention propose un dispositif du genre mentionné dans le préambule qui satisfait l'exigence précitée tout en utilisant une mémoire tampon de grande capacité.

Pour cela un tel dispositif est remarquable en ce que le circuit de régulation comporte un circuit de qualité moyenne pour déterminer une qualité moyenne pour chaque paquet de bloc d'informations, définie par la moyenne des qualités utilisées pour chaque bloc du paquet, un circuit de calcul pour fournir pour chaque bloc le nombre d'éléments binaires correspondant à ladite qualité moyenne, un circuit d'accumulation pour accumuler les différences entre le nombre fourni par le circuit de calcul et le nombre réel, un circuit de remplissage pour fournir une grandeur de remplissage représentant le rapport entre les différences accumulées et la grandeur résiduelle et un circuit de correction pour fournir une valeur de qualité corrigée en corrigeant la qualité moyenne en fonction de la grandeur de remplissage.

L'idée de l'invention repose sur l'hypothèse que pour un bloc donné le produit nombre réel par la valeur de l'inverse de la qualité est constant. La suite du présent exposé explicitera comment cette idée est mise à profit.

L'invention concerne aussi un dispositif de décodage associé au dispositif de codage.

La description suivante accompagnée des dessins ci-annexés, le tout donné à titre d'exemple non limitatif, fera bien comprendre comment l'invention peut être réalisée.

La figure 1 montre un dispositif de codage conforme à l'invention.

La figure 2 montre la décomposition d'une image en blocs.

La figure 3 montre en fonction du temps l'évolution du nombre d'éléments binaires fournis par le codeur, selon les techniques de l'art antérieur.

La figure 4 montre en détail un circuit du dispositif de la figure 1.

La figure 5 montre en détail un autre circuit du dispositif de la figure 1.

La figure 6 montre, en fonction du temps, l'évolution du nombre d'éléments fournis par le codeur, selon les mesures indiquées par l'invention.

La figure 7 montre un exemple de réalisation préféré d'un dispositif de codage conforme à l'invention.

La figure 8 montre en détail un circuit du dispositif de la figure 7.

La figure 9 montre en détail un autre circuit du dispositif de la figure 7.

La figure 10 montre, en fonction du temps, l'évolution du débit binaire après l'apparition d'un signal d'alarme.

La figure 11 montre un dispositif de décodage convenant pour un dispositif de codage de la figure 1 ou 7.

L'exemple de réalisation décrit ci-dessus se rapporte au traitement des images de télévision en vue de leur enregistrement sur bande magnétique.

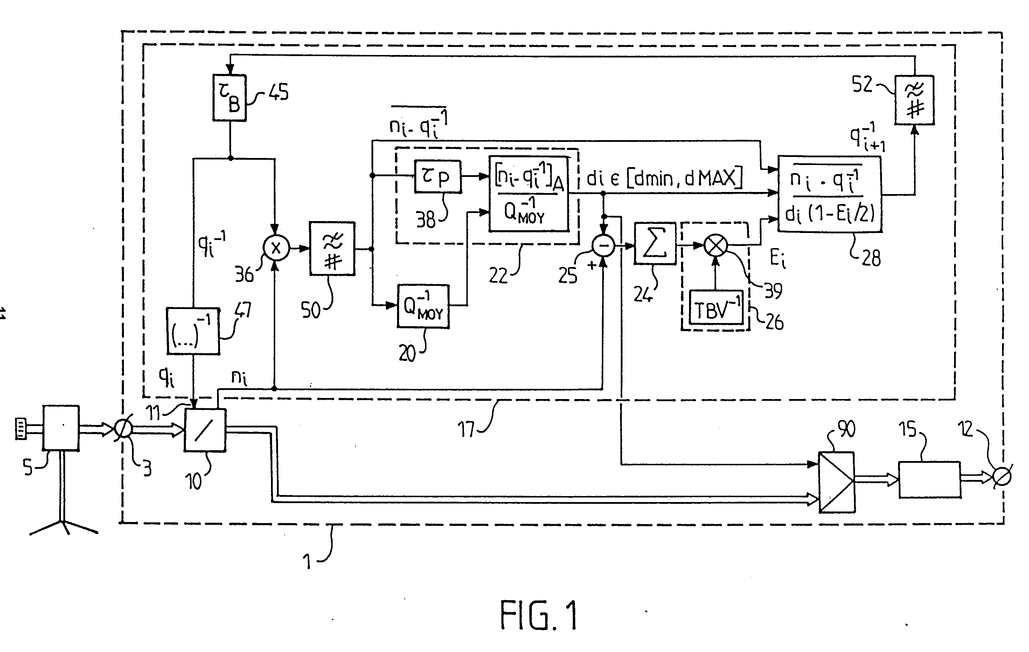

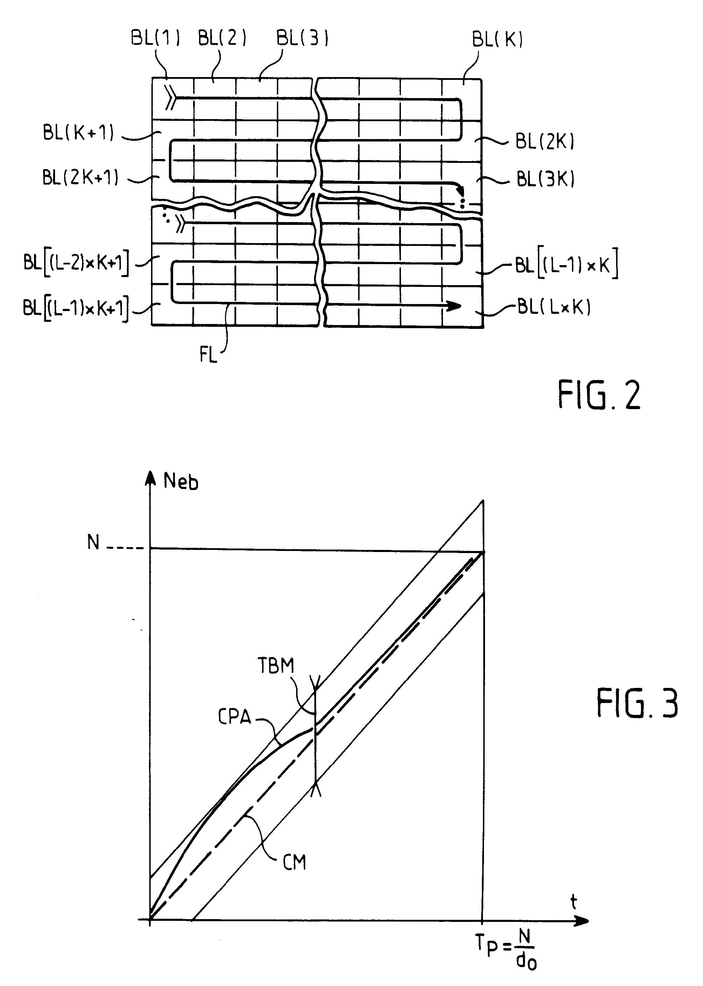

Le dispositif de codage montré à la figure 1 porte la référence 1. Sa borne d'entrée 3 reçoit les informations sous forme numérique d'une image provenant, par exemple, d'une caméra de télévision 5. Ces informations sont traitées d'abord par un codeur 10 d'un type semblable à celui décrit dans la demande de brevet européen 0 310 175 précitée. Ce codeur code des blocs d'images BL(i) dont le numéro est représenté par "i". La répartition de ces blocs est montrée à la figure 2. Chacun de ces blocs est codé avec un nombre réel $n_i$ d'éléments binaires en fonction d'un paramètre $q_i$ appelé qualité appliquée à la commande 11 du codeur 10. Pour un bloc donné, plus le paramètre $q_i$ est grand, plus le nombre $n_i$ sera élevé. Comme à la borne de sortie 12 les éléments sont fournis avec un débit fixe $d_0$, on a prévu une mémoire tampon 15 qui absorbe les fluctuations des nombres $n_i$. Un circuit de régulation 17 fournit des valeurs de paramètres $q_i$ pour qu'il n'y ait ni débordement, ni vidage de la mémoire 15. Le nombre restant d'éléments binaires peut être au maximum égal à la capacité TBM de la mémoire 15.

On a représenté à la figure 2 une répartition en L lignes et K colonnes des blocs BL(i) où i varie donc de 1 à KxL. Pour fixer les idées, chaque bloc comporte 16x16 points d'images, K = 50 et L = 40.

Pour bien comprendre l'invention, on a représenté à la figure 3, comment fonctionnent les circuits de régulation de l'art antérieur. En abscisse, on a porté le temps "t" et en ordonnée "Neb" le nombre d'éléments binaires. On s'impose de fournir N éléments binaires pour une image de durée $T_p$ ($T_p = N/d_0$). La ligne en tirets CM représente l'évolution du nombre d'éléments binaires fournis à la borne 12 et la courbe en trait plein CPA, l'évolution du nombre d'éléments binaires fournis à l'entrée de la mémoire tampon 15.

La taille TBM de la mémoire tampon 15 donne la variation admissible (du nombre d'éléments binaires de part et d'autre de la courbe CM. Cette taille représente la valeur résiduelle maximale à la fin d'une image.

La courbe CPA peut illustrer le fait que l'image analysée comporte au début de l'analyse des zones présentant beaucoup de détails et ensuite des zones sans détails, de sorte que si les premières zones à détails sont codées avec une qualité satisfaisante, les suivantes le seront avec une qualité de moins en moins satisfaisante. Les zones sans détails qui suivent sont alors codées avec une qualité superflue.

Pour éviter ce genre d'inconvénient, le circuit de régulation comporte, conformément à l'invention :

- un circuit de qualité moyenne 20 qui fournit une valeur $Q^{-1}_{MOY}$ qui est l'inverse de la qualité $Q_{MOY}$,
- un circuit de calcul 22 qui fournit pour chaque bloc BL(i) un nombre di qui est le nombre souhaité d'éléments binaires pour coder ce bloc avec la qualité $Q_{MOY}$,
- un circuit d'accumulation 24 pour accumuler les différences $(n_i - di)$, effectuées par un organe de soustraction 25,
- un circuit de remplissage 26 pour fournir une grandeur de remplissage $E_i$ représentant le rapport entre les différences accumulées et la grandeur résiduelle TBV exigée à la fin de l'analyse d'une image, et
- un circuit de correction 28 pour fournir une valeur de qualité corrigée en corrigeant la qualité moyenne en fonction de la grandeur de remplissage.

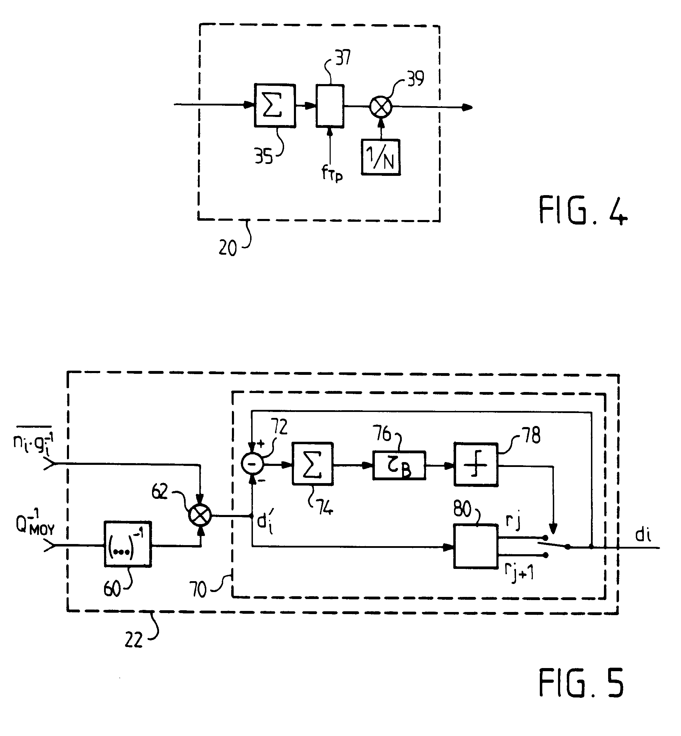

Ainsi qu'il a été dit, l'invention repose sur le fait que la quantité $n_i q_i^{-1}$ est une constante. Le circuit de qualité moyenne 20 calcule une qualité moyenne pour une image et l'on admet que cette qualité est valable pour la suivante. Ce circuit est représenté en détail à la figure 4. Il se compose d'un accumulateur 35 pour accumuler les quantités $n_i q_i^{-1}$ établies par un organe de multiplication 36 (figure 1) et d'un registre 37 pour stocker pendant la durée $T_p$ d'une image la quantité accumulée pendant l'image précédente. Un organe de multiplication 39 multiplie par 1/N la quantité contenue dans le registre 37. A la sortie de l'organe de multiplication on a donc la quantité moyenne $Q^{-1}_{MOY}$ :

$$Q^{-1}_{MOY} = \frac{\sum_{i=1}^{B} n_i q_i^{-1}}{N} \qquad (1)$$

où B est le nombre de blocs composant une image à N points ; cette formule (1) dérive de l'hypothèse précitée qui permet d'écrire pour chaque bloc BL(i) :

$$di.Q^{-1}_{MOY} = n_i q_i^{-1} \qquad (2)$$

en sommant pour les B blocs d'une image à N points

$$Q^{-1}_{MOY} \cdot \sum_{i=1}^{B} di = \sum_{i=1}^{B} n_i q_i^{-1}$$

or pour satisfaire l'exigence précitée de fournir N éléments binaires pendant une durée $T_p$ :

$$\sum_{i=1}^{B} d_i = N$$

d'où la formule (1).

Le circuit 22 qui fournit la grandeur $d_i$ profite de la relation (2). Mais ici le produit $[n_iq_i^{-1}]_A$ fourni à la sortie d'un organe de retard 38 amenant un retard $T_p$ est relatif à l'image précédente.

Comme $Q_{MOY}$ est aussi calculée sur l'image précédente, $d_i$ est une bonne valeur sur laquelle $n_i$ doit s'aligner, en admettant que les images successives se ressemblent.

Le circuit de remplissage 26 fournit, au moyen d'un organe de multiplication 39, la grandeur $E_i$ qui s'exprime par :

$$E_i = \frac{\sum\limits_{k=1}^{i} n_k - d_k}{TBV}$$

Le circuit de régulation astreint $E_i$ au domaine suivant pour satisfaire l'assurance d'une grandeur résiduelle inférieure à TBV :

$$-\tfrac{1}{2} < E_i < +\tfrac{1}{2}$$

Le circuit de correction 28 apporte une correction indiquée par la formule (3). Cette formule est établie sur les considérations suivantes :

Pour obtenir un nombre $d_i$ pour le bloc BL(i), il aurait fallu que l'inverse de la qualité soit :

$$q^{-1} = \frac{n_iq_i^{-1}}{d_i}$$

De plus, on modulera le paramètre $q^{-1}$ pour garantir une grandeur résiduelle $E_i$ aussi proche que possible de 0.

Si $E_i > 0$, il y a un excédent d'éléments binaires, alors on diminue q.

Si $E_i < 0$, il y a un déficit d'éléments binaires, alors on augmente q. Il s'ensuit :

$$q^{-1} = \frac{n_iq_i^{-1}}{d_i(1 - \tau E_i)}$$

où $\tau$ fixe la durée de convergence (en pratique $\tau = 1/2$). Cette valeur $q^{-1}$ prendra effet au bloc BL(i+1) d'où la formule (3) :

$$q_{i+1}^{-1} = \frac{n_iq_i^{-1}}{d_i(1 - \tau E_i)} \quad (3)$$

Cette valeur $q_{i+1}^{-1}$ provient d'un organe de retard 45 qui apporte le retard convenable pour qu'elle soit disponible pour le traitement du bloc BL(i+1).

Pour améliorer le fonctionnement d'un circuit de régulation 17, on a prévu un premier circuit de filtrage 50 connecté en sortie de l'organe 36. Ce circuit 50 fournit une quantité filtrée $\overline{n_iq_i^{-1}}$ donnée par l'équation suivante écrite à l'aide de l'opérateur Z de la transformée en Z :

$$\overline{n_iq_i^{-1}} = \frac{1 - \rho 1}{1 - \rho_1 Z^{-1}} n_iq_i^{-1}$$

où $0 < \rho 1 < 1$.

Ce premier circuit de filtrage 50 permet d'éviter les perturbations apportées par des changements brusques des caractéristiques locales de l'image.

C'est cette grandeur $\overline{n_iq_i^{-1}}$ qui est appliquée aux circuits 20, 22 et 28.

Un deuxième circuit de filtrage 52 est connecté en sortie du circuit 28. Sa fonction de transfert, selon la notation de tansformée en Z s'écrit :

$$\frac{1 - \rho_2}{1 - \rho_2 Z^{-1}}$$

où $0 < \rho_2 < 1$.

Ce deuxième circuit de filtrage 52 garantit une variation lente du paramètre $q_i^{-1}$.

La figure 5 montre en détail le circuit 22. Outre les organes 60 et 62 utilisés, le premier pour calculer l'inverse de la quantité $Q^{-1}_{MOY}$ et le second pour effectuer le produit $(n_iq_i^{-1})$. $Q_{MOY}$, ce circuit 22 comporte un circuit d'arrondi 70 pour fournir la valeur $d_i$.

Ce circuit comporte un organe de soustraction 72 pour effectuer la soustraction de la quantité $d_i$ fournie par la quantité $d'_i$ élaborée par l'organe 62. Les différences sont accumulées dans un accumulateur 74 ; le résultat, après un retard égal à $\tau_B$ apporté par un organe de retard 76, est appliqué à un détecteur de signe 78. La quantité $d'_i$ élaborée par l'organe 62 est traitée par un quantificateur 80 à M niveaux ; on a distingué sur la figure 5 deux niveaux consécutifs $r_j$ et $r_{j+1}$ entre lesquels est située la valeur appliquée à son entrée. Un organe de commutation 82 permet à $d_i$ de prendre l'un de ces niveaux selon la condition suivante : Si

$$\sum_{1=0}^{i-1} d'_1 - d_1 > 0$$

on a $d_i = r_{j+1}$
sinon $d_i = r_j$

De cette façon, on obtient une réduction de la dérive de $d'_1$ par rapport à la version quantifiée $d_i$.

Au premier niveau de quantification correspond un $d_{min}$ (par exemple 128 éléments binaires si chaque point du bloc est codé avec 0,5 élément binaire) et au dernier $d_{MAX}$ (par exemple 512 éléments binaires si les points du bloc sont codés chacun avec 2 éléments binaires). Les grandeurs $d_i$ sont transmises à la borne 12 par l'intermédiaire d'un multiplexeur 90 qui multiplexe ces grandeurs avec les informations de sortie du codeur 10 avant d'appliquer le total à la mémoire tampon 15.

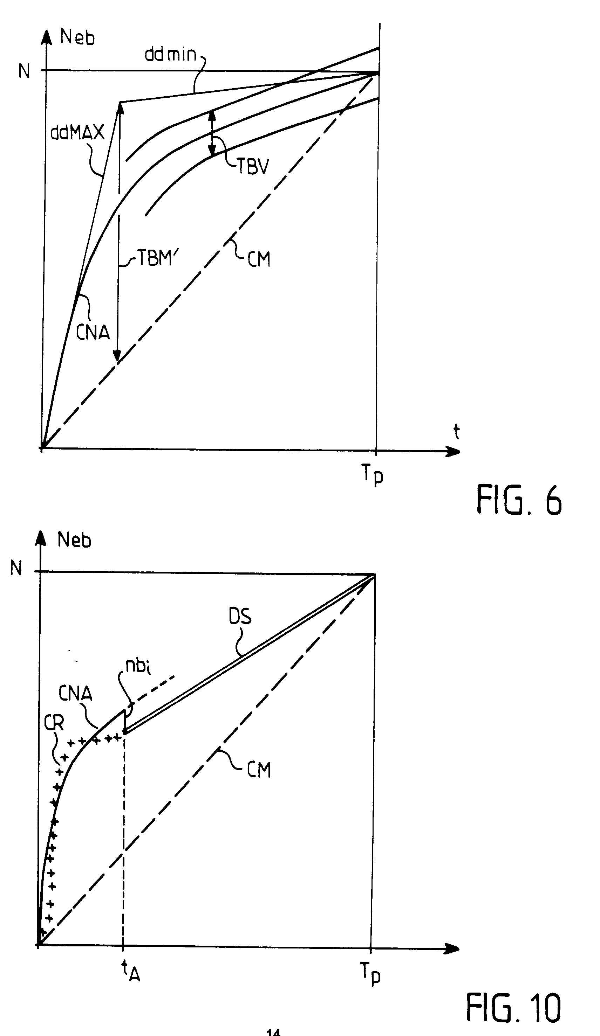

La figure 6, qui montre l'avantage apporté par l'invention est à rapprocher de la figure 3. La courbe en tirets est toujours la courbe moyenne CM. La courbe CNA est la courbe représentant l'analyse de l'image effectuée selon une qualité $Q_{MOY}$ invariable. Comme cette qualité a été déterminée sur l'image précédente, l'analyse de l'image courante peut diverger de part et d'autre de cette courbe CNA. La latitude de divergence est donnée par le paramètre TBV. On notera que la courbe CNA peut s'écarter d'une façon beaucoup plus importante de la courbe CM que la courbe CPA de la figure 3. La taille TBM' utilisable de la mémoire tampon 15 peut être évaluée de la manière suivante :
- à la valeur $d_{min}$ on associe une droite de débit $dd_{min}$ menée à l'intersection de $t = T_p$ et de la courbe CM,
- à la valeur $d_{MAX}$ on associe une droite de débit $dd_{MAX}$ menée à l'origine.

La distance entre l'intersection des droites $dd_{MAX}$ et $dd_{min}$ et la courbe CM donne la taille TBM'. En intervertissant ces deux droites on retrouve évidemment le même résultat.

Une autre mesure pour améliorer les performances du dispositif de codage conforme à l'invention consiste en un balayage judicieux des blocs d'image. Il importe, en effet, que des blocs soient analysés conjointement ; leur balayage peut être effectué comme indiqué à la figure 2 suivant la flèche FL.

Les blocs sont analysés ligne par ligne de gauche à droite pour les lignes impaires BL(1) à BL(K), ..., BL(2K+1) à BL(3X)... et de droite à gauche pour les lignes paires BL(K+1) à BL(2K) etc... Evidemment, le sens peut être inversé.

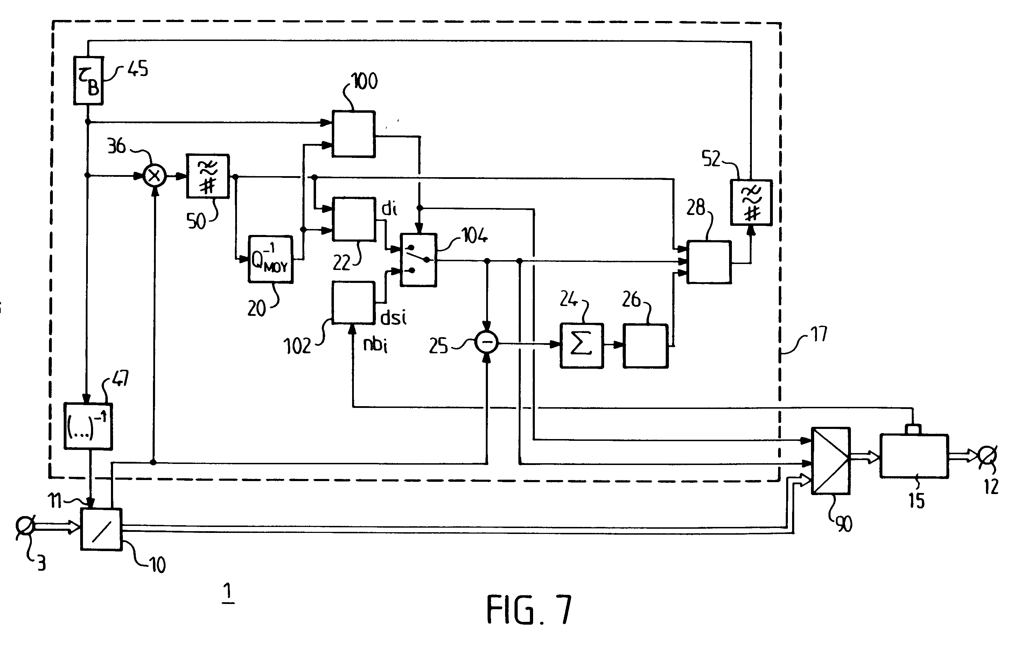

A la figure 7, on a montré un exemple de réalisation préféré d'un dispositif de codage conforme à l'invention. Les éléments communs à ceux déjà décrits portent les mêmes références.

Ce codeur se différencie de celui montré à la figure 1 par la présence d'un circuit d'alarme 100. Ce circuit 100 fournit un signal d'alarme dès que la différence entre l'inverse de la qualité appliquée à l'entrée du circuit 47 et la valeur $Q^{-1}_{MOY}$ excède une valeur "Th" prédéterminée. L'apparition de ce signal signifie le plus souvent qu'il y a rupture de séquence, donc, que ce qui a été déterminé pour une image n'est plus valable pour l'image qui suit. On ne s'asservit plus sur la valeur donnée par le circuit 22 mais sur une valeur $ds_i$ fournie par un circuit de secours 102. Le multiplexeur 90 transmet aussi, vers le décodeur, le signal d'alarme.

Un commutateur 104 dont les positions de commutation sont commandées par le signal de secours permet d'aiguiller la valeur $d_i$ ou la valeur $ds_i$ vers le circuit 28.

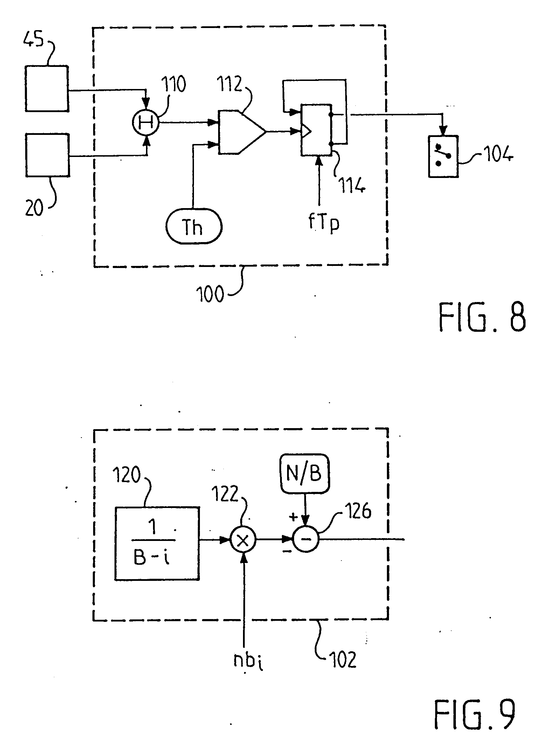

La figure 8 montre en détail le circuit d'alarme. Il se compose d'un organe de soustraction qui mesure les différences des valeurs $q^{-1}_{i+1}$ avec $Q^{-1}_{MOY}$ fournies respectivement aux sorties des circuits 45 et 20 ; ces différences sont comparées, en valeur absolue, avec une valeur préétablie Th au moyen d'un comparateur 112 ; dès qu'une différence excède le seuil Th, une bascule 114 rend actif le signal d'alarme. Cette bascule 116 est initialisée par le signal $fT_p$ à chaque image.

La figure 9 montre en détail le circuit de secours qui établit le nombre d'éléments binaires $ds_i$ à affecter aux blocs suivant l'apparition du signal d'alarme. Ce circuit évalue au moyen d'un circuit 120 l'inverse de la valeur des blocs restant à traiter. Un organe de multiplication 122 établit, en se servant de la grandeur nbi, le nombre d'éléments binaires à affecter à chaque bloc ; nbi est la quantité d'éléments binaires restant dans la mémoire tampon 15. La valeur fournie par l'organe 122 est soustraite, au moyen de l'organe de soustraction 126, de la valeur N/B qui représente le nombre d'éléments binaires moyen à affecter à chaque bloc pour traiter l'image.

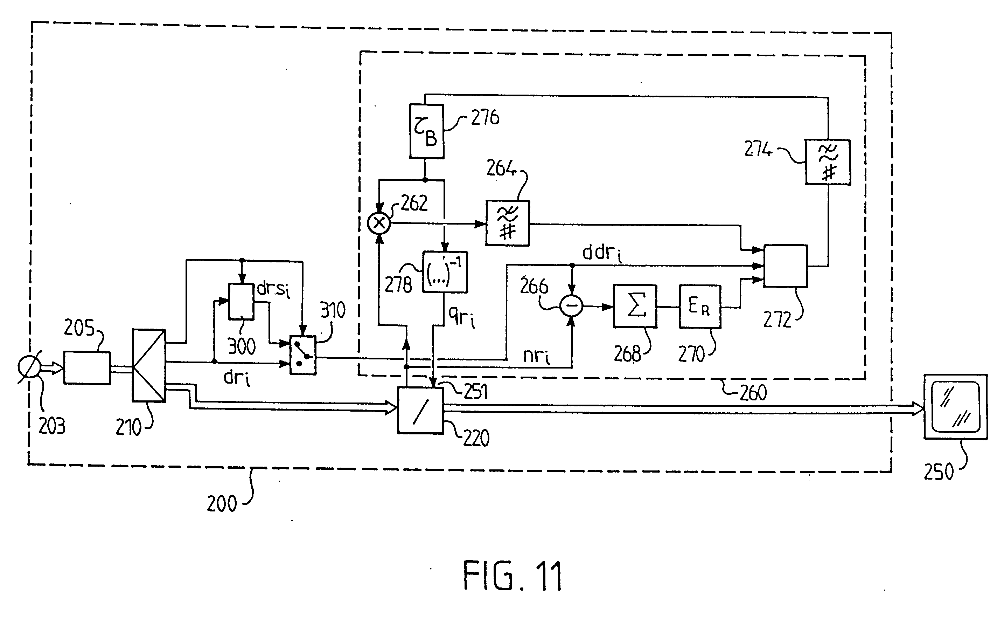

En se reportant à la figure 10, on montre l'effet des circuits 100 et 102 sur la courbe de débit. On a représenté par de petites croix la courbe réelle CR. Soit l'instant $t_A$ où survient le signal d'alarme ; on s'asservissait avant cet instant sur la courbe CNA, après cet instant on s'asservit sur la droite DS qui mène à l'intersection $t = 7_p$, Neb = N en partant du point $t = t_A$ et de la courbe CR qui est distante à cet instant $t_A$ de $nb_i$.

La figure 11 montre un circuit de décodage 200 associé à un circuit de codage conforme à l'invention.

Les données à décoder sont reçues au niveau d'une borne d'entrée 203 connectée à l'entrée d'une mémoire tampon 205. Les informations concernant $d_i$ et les informations concernant les images sont démultiplexées à la sortie de la mémoire 205 au moyen d'un démultiplexeur 210. Les informations repérées par $dr_i$ représentent les informations $d_i$ transmises. Les données contenues dans cette mémoire sont prélevées au rythme du décodage effectué par le décodeur 220 qui effectue l'opération inverse du codeur 10 des figures 1 et 7.

Les données décodées sont utilisables, alors, par un organe de visualisation 250.

Tout comme l'organe de codage 10, l'organe de décodage est muni d'une commande de qualité 251 qui détermine le pas de quantification selon lequel le codage s'est effectué. Un circuit de régulation de décodage 260 fournit les valeurs $qr_i$ à appliquer à la commande 251 en fonction du nombre $nr_i$ d'éléments binaires prélevés dans la mémoire 210 pour décoder un bloc et de la quantité $d_{ri}$ déjà explicitée.

Ce circuit de régulation 260 se compose :
- d'un organe de multiplication 262 pour évaluer le produit : $qr_i^{-1} \cdot nr_i$,
- d'un filtre passe-bas numérique 264 pour lisser les fluctuations de ce produit,
- d'un organe de soustraction 266 pour évaluer les écarts entre $dr_i$ et $nr_i$,
- d'un organe d'accumulation 268 pour sommer ces écarts durant toute une image,
- d'un circuit de remplissage pour fournir une grandeur de remplissage $Er_i$ équivalant à la grandeur $E_i$ du circuit 26 (figures 1 et 7),
- d'un circuit de correction 272 dont la fonction est la même que celle du circuit 28.

La valeur fournie par le circuit 272 est filtrée par le filtre 274, retardée par l'organe 276 et inversée par l'organe 278 avant d'être appliquée à la commande 251.

La grandeur $dr_i$ qui apparaît à la sortie du démultiplexeur 210 peut être transmise telle quelle au circuit 260, ou être enregistrée dans un registre 300 lorsque le signal d'alarme est transmis. Un commutateur 310 fournit un signal $ddr_i = dr_i$ au circuit de régulation 260 lorsqu'il n'y a pas de signal d'alarme ou un signal $ddr_i = drs_i$ lorsque le signal d'alarme apparaît. On notera que la valeur $ds_i$ reste fixe jusqu'à la fin de l'image et pourra être définie avec beaucoup de précision.

Cette conception du dispositif de décodage amène les remarques suivantes :

Les informations qi (qualité) déterminent le pas de quantification utilisé au niveau du codeur. Ces informations sont nécessaires au niveau du décodeur pour opérer la quantification inverse. Ces informations ne sont pas transmises au décodeur : il convient donc de les régénérer. Les grandeurs $q_i$ sont calculées au codeur à partir de $n_i$ (nombre de bits représentant le bloc i) et de $d_i$ (nombre de bits souhaités pour le bloc). $n_i$ est disponible côté décodeur puisqu'il est égal au nombre de bits $nr_i$ prélevé lors du décodage du bloc i, tandis que $d_i$ est transmis.

La séquence des grandeurs $q_i$ est donc recalculée au niveau du dispositif de décodage, comme elle avait été calculée au niveau du dispositif de codage. Ainsi on évite de transmettre trop d'informations supplémentaires (overhead). Il est possible d'envisager quand même la transmission de $q_i$ lorsque les blocs sont de grande taille.

## Revendications

1. Dispositif de codage comportant un codeur à mots de longueur variable (10) muni d'une commande de qualité pour déterminer des caractéristiques de codage différentes, dispositif comportant une entrée d'informations à coder (3) se présentant sous la forme de paquets de blocs d'informations numériques d'images à appliquer au codeur, une mémoire tampon (15) pour recevoir les informations codées issues dudit codeur et pour les restituer à une borne de sortie (12) avec un débit fixe et un circuit de régulation (17) pour définir pour chaque bloc une qualité en fonction d'une part du nombre réel d'éléments binaires utilisés pour le codage de chaque bloc et d'autre part d'une grandeur résiduelle définissant le nombre d'éléments binaires contenus dans la mémoire tampon après le codage de chaque paquet, caractérisé en ce que le circuit de régulation (17) comporte un circuit de qualité moyenne (20) pour déterminer une qualité moyenne pour chaque paquet de bloc d'informations, définie par la moyenne des qualités utilisées pour chaque bloc du paquet, un circuit de calcul (22) pour fournir pour chaque bloc le nombre d'éléments binaires correspondant à ladite qualité moyenne, un circuit d'accumulation (24) pour accumuler les différences entre le nombre fourni par le circuit de calcul et le nombre réel, un circuit de remplissage (26) pour fournir une grandeur de remplissage représentant le rapport entre les différences accumulées et la grandeur résiduelle et un circuit de correction (28) pour fournir une valeur de qualité corrigée en corrigeant la qualité moyenne en fonction de la grandeur de remplissage.

2. Dispositif de codage selon la revendication 1 pour lequel le codeur code selon $n_i$ éléments binaires le bloc BL(i), caractérisé en ce que la valeur de la qualité moyenne $Q_{MOY}$ est évaluée sur une image de B blocs :

$$Q^{-1}_{MOY} = i \; \frac{\sum\limits_{1}^{B} n_i \; q_i^{-1}}{N}$$

où $q_i^{-1}$ est l'inverse de la qualité utilisée pour chaque bloc, et N le contenu total d'éléments binaires consacré au codage de l'image,
et en ce que cette valeur est affectée à une image suivante.

3. Dispositif de codage selon la revendication 1 ou 2, caractérisé en ce que l'analyse d'un bloc est effectuée après celle d'un de ses voisins.

4. Dispositif de codage selon l'une des revendications 1 à 3, caractérisé en ce que il est proposé un détecteur d'écart (100) entre la valeur de qualité de bloc et la qualité moyenne pour fournir un signal d'alarme et en ce qu'il est prévu un circuit de débit constant sur lequel le circuit de régulation s'asservit dès l'apparition du signal d'alarme.

5. Dispositif de décodage convenant à un dispositif de codage de l'une des revendications précédentes comportant des moyens (90) pour émettre en plus des informations concernant l'image, des informations concernant le nombre d'éléments binaires correspondant à ladite qualité moyenne, comportant :
   - un accès (203) pour recevoir les données issues dudit dispositif de codage,
   - un démultiplexeur (210) pour fournir, d'une part, les informations concernant les images et, d'autre part, les informations concernant le nombre d'éléments binaires correspondant à ladite qualité moyenne,
   - une mémoire tampon (205) pour emmagasiner, au moins, les informations transmises concernant l'image,
   - un décodeur (220) présentant des fonctions inverses de celles dudit codeur à mots de longueur variable (10) pour recevoir, de la mémoire tampon, lesdites informations concernant les images et pour fournir, à un organe de visualisation (250), des informations numériques d'images transmises, décodeur (220) muni d'une commande de qualité pour appliquer l'indication du pas de quantification selon lequel le codage s'est effectué et d'un accès pour indiquer le nombre d'éléments binaires prélevé dans la mémoire tampon,
   caractérisé en ce qu'il comporte également un circuit de régulation pour décodage (260) se composant :
   . d'un organe de multiplication (262) pour affecter une valeur au produit sur des valeurs représentatives de celles disponibles aux commandes de qualité et audit accès dudit décodeur,
   . d'un organe de soustraction (266) pour évaluer les écarts entre les informations concernant le nombre d'éléments binaires correspondant à ladite qualité moyenne et les informations audit accès du décodeur,
   . d'un circuit de remplissage (270) pour fournir une grandeur de remplissage équivalant à celle produite par le circuit de remplissage du dispositif de codage,
   . d'un circuit de correction (272) dont la fonction est équivalente à celle du circuit de correction du dispositif de codage et qui fournit donc la grandeur de qualité pour ladite commande du décodeur.

6. Dispositif de décodage selon la revendication 5 convenant à un dispositif de codage de la revendication 4 comportant des moyens (90) pour émettre en plus des informations concernant l'image, des informations concernant le nombre d'éléments binaires correspondant à ladite qualité moyenne et des informations concernant ledit signal d'alarme, caractérisé en ce qu'il est prévu un registre (300) pour emmagasiner jusqu'à la fin de l'image les informations concernant le nombre d'éléments binaires correspondant à ladite qualité moyenne, à la réception dudit signal d'alarme.

## Claims

1. A coding arrangement including a variable-length word encoder (10) having a quality control to determine different coding characteristics, the arrangement comprising an input for information components to be encoded (3) and which are provided in the form of packets of digital picture information blocks to be applied to said coder, a buffer store (15) to receive the coded information outputted by the said coder and to produce them at an output terminal (12) at a fixed rate, and a regulating circuit (17) for defining for each block a quality as a function of on the one hand the real number of bits utilized for coding each block and on the other hand a residual quantity which defines the number of bits contained in the buffer store after coding of each packet, characterized in that the regulating circuit (17) comprises a quality circuit (20) to determine an average quality for each packet of information blocks, defined by the average of the qualities used for each block of the packet, a calculating circuit (22) to provide for each block the number of bits corresponding to the said average quality, an accumulator circuit (24) for accumulating the differences between the number furnished by the calculation circuit and the real number, a filler circuit (26) for supplying a fill quantity representing the ratio between the accumulated differences and the residual quantity and a correction circuit (28) for supplying a corrected quality value by correcting the average quality as a function of the fill quantity.

2. A coding arrangement as claimed in Claim 1, for which a block BL(i) is encoded into Ni bits , characterized in that the value of the average quality $Q_{MOY}$ is evaluated over a B block picture:

$$Q_{MOY}^{-1} = i \; \frac{\displaystyle\sum_{1}^{B} n_i \, q_i^{-1}}{N}$$

wherein $q_i^{-1}$ is the inverse of the quality utilized for each block, and N the total content of the bits dedicated to the encoding of the picture, and in that this value is assigned to a subsequent picture.

3. A coding arrangement as claimed in Claim 1 or 2, characterized in that the analysis of a block is effected after the evaluation of one of its neighbouring blocks.

4. A coding arrangement as claimed in any one of the Claims 1 to 3, characterized in that a detector (100) is proposed for detecting the deviation between the block quality value and the average quality to supply an alarm signal and in that a constant rate circuit is provided on which the regulating circuit acts as soon as the alarm signal appears.

5. A decoding device suitable for use with a coding arrangement as claimed in any one of the preceding Claims, comprising means (90) for also transmitting picture information components, information components relating to the number of bits corresponding to said average quality, comprising:
   - an input (203) for receiving the data from said coding arrangement,
   - a demultiplexer (21) for providing the picture information components and the information components relating to the number of bits corresponding to said average quality,
   - a buffer memory (205) for storing at least the transmitted picture information components,
   - a decoder (220) having functions inverse to those of said variable-length word coder (10) for receiving said picture information components from the buffer memory, and for applying transmitted digital picture information components to a display member (250), said decoder (220) having a quality control for applying the quantization step indication according to which coding is effected and an input for indicating the number of bits taken from the buffer memory,

   characterized in that it is also comprises a regulating circuit (260) comprising:
   - a multiplying member (262) for assigning a value to the product of values representative of those available at the quality controls and at said input of the decoder,
   - a subtracting member (266) for evaluating the deviations between the information components relating to the number of bits corresponding at the input of the decoder,
   - a fill circuit (270) for supplying a fill quantity equivalent to that produced by the fill circuit of the coding arrangement,
   - a correction circuit (272) whose function is equivalent to that of the correction circuit of the coding

8

arrangement and which thus applies the quality value for said decoder control.

6. A decoding arrangement as claimed in Claim 5, which is a coding arrangement as claimed in Claim 4, comprising means (90) for also transmitting picture information components, information components relating to the number of bits corresponding to said average quality and information components relating to said alarm signal, characterized in that it is provided with a register (300) for storing, until the end of the picture, the information components relating to the number of bits corresponding to said average quality, upon reception of said alarm signal.

## Patentansprüche

1. Kodierungsgerät, das einen Koder für Worte mit variabler Länge (10) enthält und das mit einem Befehl mit der Eigenschaft ausgestattet ist, die verschiedenen Kodierungs-Charakteristika zu determinieren, sowie mit einer Vorrichtung, die einen Eingang (3) für die zu kodierenden Informationen hat, die in Form von Paketen numerischer Informationsblöcke von Bildern auftreten, sowie mit einem Pufferspeicher (15) für den Empfang kodierter Informationen, welche von dem besagten Koder ausgegeben worden sind, um sie an einer Durchführungsklemme (12) mit einer festen Übertragungsgeschwindigkeit zu rekonstruieren, sowie mit einer Regulierungsschaltung (17), um für jeden Block eine Qualität zu definieren, einesteils in Abhängigkeit von der Anzahl der tatsächlich für die Kodierung jedes Blocks verwendeten Binärelemente und anderenteils von einer Restgröße, die die Anzahl der Binärelemente definiert, die in jedem Pufferspeicher nach der Kodierung jedes Pakets enthalten sind, welches dadurch charakterisiert wird, daß die Regulierungsschaltung (17) eine Mittelbeschaffenheitsschaltung (20) zur Determinierung einer mittleren Qualität für jeden Block mit Informationen enthält, der durch den Mittelwert der Qualität definiert ist, die jeder Block des Paketes verwendet, sowie eine Berechnungsschaltung (22), um für jeden Block die Anzahl Binärelemente zu liefern, die der genannten mittleren Qualität entsprechen, sowie eine Kumulierungsschaltung (24), um die Differenzen zwischen der von der Berechnungsschaltung gelieferten Anzahl und der tatsächlichen Anzahl zu akkumulieren, sowie eine Befüllungsschaltung (26), um eine Füllgröße zu liefern, die das Verhältnis zwischen den akkumulierten Differenzen und der Restgröße repräsentiert, sowie eine Korrekturschaltung (28), um einen Wert mit korrigierter Qualitat zu liefern, indem die mittlere Qualität in Abhängigkeit von der Befüllungsgröße korrigiert wird.

2. Kodierungsvorrichtung gemäß Patentanspruch 1, bei der der Koder den Block BL(i) gemäß $n_i$ Binärelementen kodiert, dadurch charakterisiert, daß der Wert der mittleren Qualität $Q_{MOY}$ an einem Bild mit B Blöcken untersucht wird :

$$Q^{-1}_{MOY} = i\ \frac{\sum\limits_{1}^{B} n_i \bar{q}_i^1}{N}$$

wobei $q_i^{-1}$ der Kehrwert der für jeden Block verwendeten Qualität ist und N der Gesamtinhalt der für die Kodierung des Bildes bestimmten Binärelemente ist und wobei dieser Wert für das folgende Bild verwendet wird.

3. Kodierungsgerät gemäß Patentanspruch 1 oder 2, dadurch charakterisiert, daß die Analyse eines Blocks nach derjenigen einer seiner Nachbarblöcke ausgeführt wird.

4. Kodierungsgerät gemäß einem der Patentansprüche 1 bis 3, dadurch charakterisiert, daß er mit einem Abweichungsdetektor (100) für die Abweichung zwischen dem Qualitätswert des Blocks und der mittleren Qualität ausgestattet ist, der ein Alarmsignal liefert, sowie dadurch, daß er mit einer Schaltung mit konstanter Übertragungsgeschwindigkeit ausgestattet ist, derer sich die Regulierungsschaltung nach Auftreten des Alarmsignals bedient.

5. Zum Kodierungsgerät nach einem der vorgenannten Patentansprüche gehörende Dekodierungsvorrichtung, die die Vorrichtungen (90) enthält, um zusätzlich das Bild betreffende Informationen sowie Informationen über die der besagten mittleren Qualität entsprechende Anzahl der Binärelemente auszusenden, sowie ausgestattet mit:

- einem Zugang (203) zum Empfang der vom besagten Kodierungsgerät ausgesendeten Daten;
- einem Demultiplexierer (210), um einesteils die die Bilder betreffenden Informationen und andernteils die die Anzahl der Binärelemente betreffenden Informationen zu liefern, die der besagten mittleren Qualität entsprechen;
- einem Pufferspeicher (205), um zumindest die übermittelten Informationen zu speichern, die das Bild betreffen;
- einem Dekodierer (220), der die umgekehrten Funktionen aufweist, wie die des besagten Koders mit variabler Länge (10), um vom Pufferspeicher die besagten, die Bilder betreffenden Informationen zu empfangen sowie einem Visualisationselement (250), um die übermittelten numerischen Informationen zu liefern, wobei der Dekodierer (220) mit einem Qualitätsbefehl ausgestattet ist, um die Anzeige des Quantifikationsrhythmus gemäß dessen die Kodierung ausgeführt wird, zuzuordnen, sowie mit einem Zugang zum Anzeigen der Anzahl der Binärelemente, die vom Pufferspeicher abgegriffen wird, der dadurch gekennzeichnet ist, daß er außerdem Folgendes enthält ein Regulierungsschaltung für Dekodierung (260) bestehend aus :
- ein Multiplikationsglied (262) um dem Produkt aus den für die Qualitätsbefehle verfügbaren repräsentativen Werten und dem besagten Zugang des besagten Dekodierers einen Wert zuzuweisen;
- ein Substraktionsglied (266) zur Untersuchung der Abweichungen zwischen den Informationen, die die Anzahl der Binärelemente betreffen, welche der besagten mittleren Qualität entsprechen und den Informationen des besagten Zugangs zum Dekodierer;
- eine Befüllungsschaltung (270) zur Lieferung einer Befüllungsgröße, die der von der Befüllungsschaltung des Kodierungsgerätes produzierten entspricht;
- eine Korrekturschaltung (272), deren Wirkung der der Korrekturschaltung des Kodierungsgerätes gleicht und welche somit eine Qualitätsgröße für den besagten Befehl des Dekodierers liefert.

6. Zum Koder des Patentanspruchs 4 gehörende Dekodiervorrichtung gemäß Patentanspruch 5, welche Vorrichtungen (90) enthält, um zusätzlich zu den das Bild betreffenden Informationen Informationen auszusenden, die die Anzahl der Binärelemente betreffen, die der besagten mittleren Qualität entsprechen, sowie Informationen auszusenden, die das besagte Alarmsignal betreffen, und die außerdem dadurch charakterisiert ist, daß sie mit einer Speicherzelle (300) zur Speicherung der Informationen bis zum Ende des Bildes, welche die Anzahl der Binärelemente betreffen, die der besagten mittleren Qualität entsprechen, sowie zum Empfang des besagten Alarmsignals ausgestattet ist.

FIG. 1

EP 0 425 051 B1

BL(1)   BL(2)   BL(3)                    BL(K)

BL(K+1)                                  BL(2K)

BL(2K+1)                                 BL(3K)

BL[(L-2)×K+1]                            BL[(L-1)×K]

BL[(L-1)×K+1]                            BL(L×K)

FL

# FIG. 2

Neb

N

TBM

CPA

CM

$T_P = \dfrac{N}{d_0}$

t

# FIG. 3

12

FIG. 4

FIG. 5

FIG. 6

FIG. 10

FIG. 7

FIG. 8

FIG.9

FIG. 11